# EUROPEAN PATENT APPLICATION

(11) **EP 4 134 162 A1**
(43) Date of publication of application: **15.02.2023**
(21) Application number: 21784346.5
(22) Date of filing: 31.03.2021
(51) Int. Cl.: B01J 37/02, B01J 23/42, C23C 16/455, C23C 16/44, C23C 16/40

(54) **METHOD FOR MANUFACTURING METAL CATALYST HAVING INORGANIC FILM DEPOSITED THEREON BY MEANS OF ALD PROCESS INTO WHICH MAINTENANCE STEP IS INTRODUCED, AND METAL CATALYST MANUFACTURED THEREBY**

(30) Priority: 08.04.2020 KR 20200042645
(71) Applicant: Hanwha Solutions Corporation, Jung-gu Seoul 04541 (KR); Korea Advanced Institute of Science and Technology, Daejeon 34141 (KR)
(72) Inventor: CHO, Young Jin, Daejeon 34128 (KR); KIM, Do Heung, Daejeon 34128 (KR); WOO, Eun Ji, Daejeon 34128 (KR); JANG, Won Tae, Daejeon 34141 (KR); CHOI, Keon Woo, Daejeon 34141 (KR); IM, Sung Gap, Daejeon 34141 (KR)
(74) Representative: Klunker IP Patentanwälte PartG mbB
(86) International application number: PCT/KR2021/003976
(87) International publication number: WO 2021/206356

(57) **Abstract**

The present invention relates to a method for manufacturing a metal catalyst having an inorganic film deposited thereon using an atomic layer deposition (ALD) process. More specifically, the present invention aims to provide optimal process conditions by introducing a maintenance step into an ALD process. Accordingly, it is possible to uniformly deposit the inorganic film even on the internal structure of a porous catalyst and to provide excellent catalytic activity and sintering prevention effect.

## Description

### TECHNICAL FIELD

The present invention relates to a method for manufacturing a metal catalyst having an inorganic film deposited thereon by using an atomic layer deposition (ALD) process. More specifically, the present invention aims to provide optimal process conditions by introducing a maintenance step into an ALD process. Accordingly, it is possible to uniformly deposit the inorganic film even on an internal structure of a porous catalyst and to provide excellent catalytic activity and sintering prevention effect.

### BACKGROUND ART

Atomic layer deposition (ALD) refers to a deposition method for growing a thin film in units of atomic layers. In the case of general chemical vapor deposition, reactants are injected at the same time and a surface reaction is performed together with a gas phase reaction. However, in the case of ALD, a vapor phase reaction is suppressed through sequential injection of reactants and deposition is performed by a surface reaction through self-limited adsorption on a surface of a deposition target. Since the thickness of the entire deposited film is controlled through the number of deposition cycles, there is an advantage that can easily control the thickness in units of atomic layers. In addition, due to various types, good thin film properties, and excellent properties of processing or the like even at relatively low temperatures, development has been made by mainly applying to semiconductor dielectrics, magnetic materials, and the like. However, with the recent development of nanotechnology, the ALD of inorganic materials has been actively studied in various fields in recent years, departing from the trend of research focusing on traditional integrated circuit devices. In particular, studies to apply to catalyst surface coating is currently actively in progress.

For example, Japanese Patent Laid-Open No. 2014-522797 relates to a metal catalyst composition and a method for manufacturing the same. The metal catalyst composition can be manufactured by: a step (a) of contacting a supported metal catalyst surface with a ligand-containing alumina precursor for a predetermined contact time to form an intermediate layer having a plurality of aluminum moieties chemically bonded to the supported metal catalyst surface and a step of contacting the intermediate layer with an inert gas to remove unreacted ligand-containing alumina precursors; a step (b) of reacting the aluminum moieties with an oxidizing agent so that at least a part of the ligand is converted into hydroxyl, thereby forming an alumina over-coating layer on the supported metal catalyst surface or the previously formed alumina coating layer; a step (c) of contacting the alumina over-coating layer formed in step (b) with an inert gas to remove an unreacted oxidizing agent and repeating the sequential steps (a) to (c) to form an additional layer of alumina over-coating; and a step (d) of, after forming a final layer of the alumina over-coating, activating the alumina over-coating layer to form a plurality of pores therein. That is, a method for coating a catalyst with alumina at an atomic layer level using an ALD process is disclosed. Accordingly, it can be applied to olefin production, etc., and can provide an effect of preventing a sintering phenomenon or the like. However, in the case of the catalyst according to the above manufacturing method, there are some limitations in that there is no disclosure that the catalytic activity and sintering prevention effect can be maintained even at high temperature.

Next, as Non-Patent Literature, a paper "Science 335 (6073)" relates to a technology for depositing an Al₂O₃ thin film on a Pd/Al₂O₃ catalyst. It is disclosed that when a thin film is deposited with Al₂O₃ 45 cycles according to an ALD process, the activity is rather reduced because all Pd active sites are blocked, this can be confirmed by a Kubelka Munk peak representing a CO chemisorption value, and it is possible to confirm that the peak disappears simply after deposition without posttreatment. In addition, according to the above process, when the catalyst is heat-treated at a high temperature of 675°C or higher, micropores are formed in Al₂O₃ deposited on the Pd active site. The microporous Al₂O₃ thin film formed in this way can easily react with reactants, but the mutual reaction between Pd metals or the reaction between Pd metal and carbon can be prevented to solve the problem of sintering and coking.

Finally, as Non-Patent Literature, a paper "Chinese Journal of Chemical Physics 29, 571 (2016)" relates to a technology for depositing TiO₂ and Al₂O₃ on Au/TiO₂ by using an ALD process. It is disclosed that a catalyst deposited in optimal ALD process conditions show thermal stability even at a high temperature, has an activity similar to that of a bare catalyst, and it is possible to confirm that a thin film deposited after an ALD process shows a sintering prevention effect.

As described above, various research and development have been conducted into the catalysts having the thin film coated thereon by using the ALD process. As part of these studies, the present invention has been completed as a result of studying a method for maintaining higher catalytic activity and providing a sintering prevention effect in an ALD process.

### [Citation List]

(Patent Literature 1) Japanese Patent Laid-Open No. 2014-522304 (2012.12.06)
(Non-Patent Literature 2) Science 335 (6073), 1205-1208
(Non-Patent Literature 3) Chinese Journal of Chemical Physics 29, 571 (2016), 571-577

### DESCRIPTION OF EMBODIMENTS

### TECHNICAL PROBLEM

The present invention aims to solve the above-described problems.

An object of the present invention is to provide optimal process conditions by introducing a maintenance step into an atomic layer deposition (ALD) process.

An object of the present invention is to sufficiently infiltrate reactants into a catalyst to maintain the activity of the catalyst and provide a sintering prevention effect at the same time.

### SOLUTION TO PROBLEM

In order to achieve the above-described objects of the present invention and realize the characteristic effects of the present invention described below, the characteristic configuration of the present invention is as follows.

According to an embodiment of the present invention, a method for manufacturing a metal catalyst having an inorganic film deposited thereon by an atomic layer deposition (ALD) process, the method including: a step (a) of injecting a precursor into a supported catalyst according to ALD to deposit the precursor on the surface of the catalyst; a step (b) of performing maintenance; a step (c) of performing purging; a step (d) of depositing an inorganic film on the surface of the catalyst by injecting an oxidizing agent into the supported catalyst and reacting the oxidizing agent with the precursor deposited on the surface of the catalyst; a step (e) of performing maintenance; and a step (f) of performing purging.

According to an embodiment of the present invention, the catalyst in the step (a) is at least one selected from platinum (Pt), gold (Au), silver (Ag), copper (Cu), nickel (Ni), palladium (Pd), rhodium (Rh), and ruthenium (Ru).

According to an embodiment of the present invention, the supporting in the step (a) provides at least one selected from alumina, silica, zeolite, titania, zirconia, and carbon as a support.

According to an embodiment of the present invention, the precursor in the step (a) is a precursor capable of forming at least one selected from alumina (Al₂O₃), titania (TiO₂), zirconia (ZrO₂), zinc oxide (ZnO₂), gallium oxide (GaO₂), and ceria (CeO₂).

According to an embodiment of the present invention, the oxidizing agent in the step (d) is at least one selected from ultrapure purified water, alcohol, ozone, nitrous oxide, and oxygen.

According to an embodiment of the present invention, the inorganic film in the step (d) is at least one selected from alumina, titania, zirconia, zinc oxide, gallium oxide and ceria.

According to an embodiment of the present invention, an injection time of the injecting in the steps (a) and (d) is 0.5 seconds to 30 seconds.

According to an embodiment of the present invention, the injecting in the steps (a) and (d) is performed by injecting an inert gas as a carrier gas.

According to an embodiment of the present invention, the maintenance in the steps (b) and (e) is performed at a temperature of 100°C to 900°C.

According to an embodiment of the present invention, the maintenance in the steps (b) and (e) is performed at a temperature of 50°C to 300°C.

According to an embodiment of the present invention, the maintenance in the steps (b) and (e) is performed at a pressure of 1 to 10 torr.

According to an embodiment of the present invention, the maintenance in the steps (b) and (e) is performed in a closed space.

According to an embodiment of the present invention, the purging in the (c) and (f) is performed by injecting an inert gas.

According to an embodiment of the present invention, the purging in the steps (c) and (f) is performed at a pressure of 0.001 to 1 torr.

According to an embodiment of the present invention, an atomic layer is deposited by performing the method 1 to 10 cycles.

According to an embodiment of the present invention, a metal catalyst manufactured by the method described above is provided. In this case, the thickness of the inorganic film is 0.1 to 2 nm.

### ADVANTAGEOUS EFFECTS OF DISCLOSURE

According to the present invention, optimal process conditions can be provided by introducing the maintenance step into the ALD process. In particular, in the case of introducing the maintenance step, it can be even when the reactant injection time is reduced, the reactant penetrates into the internal structure of the porous catalyst, and thus, the adsorption of additional reactants affecting the activity and the sintering prevention effect can be suppressed.

According to the present invention, in the case of introducing the maintenance step into the ALD process, it can be confirmed that the activity improvement can be provided differently depending on the ALD process conditions, and the same activity can be provided even after calcination under certain conditions.

### BRIEF DESCRIPTION OF DRAWINGS

FIG. 1 is a result of measuring catalytic activities of Example 1 of the present invention and Comparative Example 1.
FIG. 2 is a result of measuring catalytic activities of Example 1 of the present invention and Comparative Example 1.
FIG. 3 is a result of measuring catalytic activities of Comparative Examples 1 to 4 of the present invention.
FIG. 4 is a result of measuring catalytic activities of Examples 1 and 2 of the present invention and Comparative Example 1.

### MODE OF DISCLOSURE

Reference is made to the accompanying drawing which shows, by way of illustration, specific embodiments in which the present invention can be practiced. The embodiments will be described in detail in such a manner that the present invention can be carried out by those of ordinary skill in the art. It should be understood that various embodiments of the present invention are different from each other, but need not be mutually exclusive. For example, certain shapes, structures, and features described herein may be implemented in other embodiments without departing from the spirit and scope of the present invention in connection with one embodiment. In addition, it will be understood that the locations or arrangement of individual components in the disclosed embodiments can be changed without departing from the spirit and scope of the present invention. Therefore, the following detailed description is not to be taken in a limiting sense, and the scope of the present invention is to be limited only by the appended claims and the entire scope of equivalents thereof, if properly explained.

Hereinafter, preferred embodiments of the present invention will be described in detail with reference to the accompanying drawing, so that those of ordinary skill in the art can easily carry out the present invention.

According to an embodiment of the present invention, atomic layer deposition (ALD) refers to a deposition method for growing a thin film on a surface of a catalyst in units of atomic layers. A method for manufacturing a catalyst having a metal thin film coated thereon by using ALD.

According to an embodiment of the present invention, there is provided a method for manufacturing a metal catalyst having an inorganic film deposited thereon by an ALD process, the method including: a step (a) of injecting a precursor into a supported catalyst according to ALD to deposit the precursor on a surface of a catalyst; a step (b) of performing maintenance; a step (c) of performing purging; a step (d) of injecting an oxidizing agent into the supported catalyst and reacting the oxidizing agent with the precursor deposited on the surface of the catalyst to deposit an inorganic film on the surface of the catalyst; a step (e) of performing maintenance; and a step (f) of performing purging.

First, according to an embodiment of the present invention, the step (a) of injecting the precursor into the supported catalyst according to the ALD to deposit the precursor on the surface of the catalyst is provided. In this case, the catalyst in the step (a) may be at least one selected from platinum (Pt), gold (Au), silver (Ag), copper (Cu), nickel (Ni), palladium (Pd), rhodium (Rh), and ruthenium (Ru). Preferably, the catalyst may be platinum (Pt).

In addition, the support provided in the supporting in the step (a) may be at least one selected from alumina (Al₂O₃), silica (SiO₂), titania (TiO₂), zirconia (ZrO₂), zeolite, and carbon. Preferably, the catalyst may be supported in an alumina (Al₂O₃) support. The carbon support is not particularly limited, but at least one selected from activated carbon, carbon black, graphite, graphene, ordered mesoporous carbon (OMC), and carbon nanotubes may be used.

The supporting includes impregnation or immersion. The specific surface area of the provided support may be measured by a commonly used BET method, and may be 5 to 300 m²/g. Accordingly, thermal stability can be ensured and sufficient dispersion and catalytic activity can be provided.

In addition, the precursor injected into the supported catalyst may be a reactant capable of forming at least one selected from alumina (Al₂O₃), titania (TiO₂), zirconia (ZrO₂), zinc oxide (ZnO₂), gallium oxide (GaO₂) and ceria (CeO₂). Preferably, trimethyl alumina (TMA) that forms alumina (Al₂O₃) may be provided. When the precursor is injected into the supported catalyst, the precursor starts to be deposited on the surface of the catalyst.

In addition, in the case of a precursor capable of forming alumina, an organoaluminum compound may be provided. For example, isobutyl aluminum, dimethyl aluminum, triethyl aluminum, trimethyl aluminum, triacebutyl aluminum, and the like may be provided. The aluminum precursor may be provided in the form of a hydride and a complex salt, and the present invention is not limited thereto.

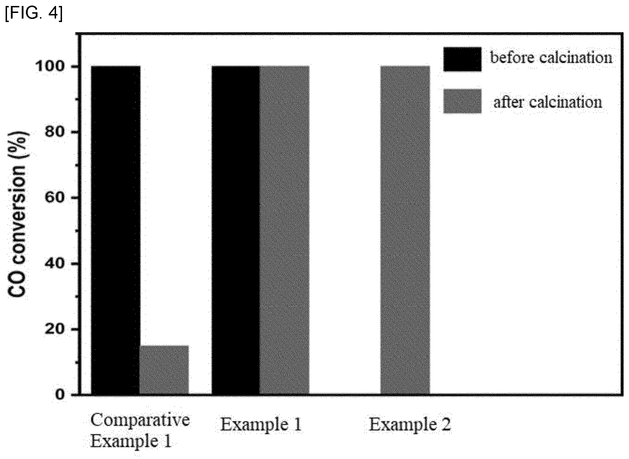

In addition, the injecting in the step (a) is characterized in that the injection time is 0.5 seconds to 30 seconds. In particular, referring to results of FIG. 4 to be described below, it can be confirmed that when the maintenance step according to the present invention is introduced, the activity of the catalyst is not affected and there is a sintering prevention effect, even when the reactant injection time is reduced. This is meaningful in that it is confirmed that the maintenance step rather than the reactant injection time in the ALD process is an important process to uniformly coat up to the inside of the catalyst.

In addition, the injecting in the step (a) is performed by injecting an inert gas as a carrier gas. The provided inert gas may be, for example, nitrogen, helium, neon, argon, and the like, and the present invention is not limited thereto.

According to an embodiment of the present invention, the step (b) of performing the maintenance is performed after the step (a). That is, in the present invention, the maintenance step is provided so that the precursor can be sufficiently deposited inside the porous catalyst.

In this case, the maintenance step is performed in a closed space. The closed space means a closed batch state and is provided by maintaining a certain time in a closed space. In this case, the certain time may be 100 seconds to 900 seconds. The certain time may be preferably in the range of 400 seconds to 800 seconds, and more preferably in the range of 500 seconds to 700 seconds.

After the maintenance step is performed within the above time range in the closed batch state, the reactant can be induced to sufficiently penetrate into the structure of the porous catalyst, thereby enabling uniform deposition into the inside of the catalyst. In addition, there is no need for additional injection of reactants. and thus adsorption of additional reactants outside the catalyst can be prevented.

In addition, the maintenance step is performed at a temperature of 50°C to 300°C. The maintenance step is performed at a pressure of 1 to 10 torr. The maintenance step is performed at a temperature of 150°C and a pressure of 3 torr. In these conditions, the excellent effect sought by the present invention can be provided.

According to an embodiment of the present invention, after the step (b), the step (c) of performing the purging is provided. The purging means purification or removal. For example, the inert gas may be injected to provide an internal pressure of 0.001 to 1 torr. When the pressure exceeds 1 torr, it may mean that reactive precursors or purging gas remain. Accordingly, adsorption of additional reactants can be prevented by adjusting the pressure of the provided gas. The inert gas may be, for example, nitrogen, helium, neon, argon, and the like, and the present invention is not limited thereto.

According to an embodiment of the present invention, the step of depositing the inorganic film on the surface of the catalyst by injecting the oxidizing agent into the supported catalyst and reacting the oxidizing agent with the precursor deposited on the surface of the catalyst is provided. In this case, the provided oxidizing agent may include ultrapure purified water, alcohol, ozone, nitrous oxide, oxygen, and the like, and the present invention is not limited thereto. Ultrapure purified water may be preferably provided.

According to an embodiment of the present invention, when the inorganic film starts to be deposited according to the step (d), the step (e) of performing the maintenance is provided. In this case, the provided conditions may be the same as those described in the step (b) of performing the maintenance. That is, the inorganic film can be sufficiently deposited inside the porous catalyst through the maintenance step. In this case, the inorganic film to be deposited may be at least one selected from alumina, titania, zirconia, zinc oxide, gallium oxide, and ceria. The inorganic film to be deposited may be preferably alumina (Al₂O₃).

According to an embodiment of the present invention, after the step (e) of performing the maintenance, the step (f) of performing the purging is provided. In this case, the provided conditions may be the same as those described in the step (c) of performing the purging.

According to an embodiment of the present invention, an atomic layer may be deposited by performing the method for manufacturing the metal catalyst 1 to 10 cycles. Preferably, 3 to 5 cycles may be provided. One cycle means a series of flows of the steps (a) to (f). In particular, since the present invention includes the maintenance step, the uniform inorganic film can be provided even though the number of cycles is 10 or less, and uniform coating can be provided up to the inside of the porous catalyst. Accordingly, an efficient production process can be provided.

According to an embodiment of the present invention, there is provided a metal catalyst having an inorganic film deposited thereon, which is manufactured by the manufacturing method described above. Hereinafter, the same description as that of the method for manufacturing the catalyst may be applied, and redundant descriptions will be omitted.

According to an embodiment of the present invention, the inorganic film of the metal catalyst having the inorganic layer deposited thereon may be deposited to a thickness of 0.1 to 2 nm. For example, it is possible to provide the metal catalyst in which alumina (Al₂O₃) is uniformly deposited to a thickness of 0.1 to 2 nm as the inorganic film inside the porous catalyst through the maintenance step.

In addition, since the thickness deposited by one cycle can be provided in the range of 0.02 to 0.1 nm, the thickness of the metal thin film can be freely and appropriately modified at the level of those of ordinary skill in the art by adjusting or repeating the number of cycles as necessary.

According to an embodiment of the present invention, the metal catalyst having the inorganic film deposited thereon according to the present invention may be in the form of powder, particles, granules, and pellets. Preferably, the metal catalyst according to the present invention may be provided in the form of powder or particles.

According to an embodiment of the present invention, the metal catalyst having the inorganic film deposited thereon may be applied to a carbon monoxide oxidation reaction. In particular, in the carbon monoxide oxidation reaction that is performed at a high temperature of 100°C to 300°C, high catalytic activity of the catalyst and prevention of sintering can be provided at the same time.

Hereinafter, the structure and operation of the present invention will be described in more detail with reference to preferred examples of the present invention. However, these examples are shown by way of illustration and should not be construed as limiting the present invention in any sense. Since contents not described herein can be sufficiently technically inferred by those of ordinary skill in the art, descriptions thereof will be omitted.

### Example 1

Trimethyl alumina (TMA, 99.999%, EG chem. Co., Ltd.) as an alumina precursor was injected into an alumina (Al₂O₃)-supported platinum (Pt) catalyst with nitrogen gas as a carrier gas at 150°C and 1 torr for 15 seconds. Thereafter, maintenance was performed in a closed batch at 150°C and 3 torr for 600 seconds. After the maintenance, purging was performed at 150°C and 1 torr for 600 seconds.

Next, ultrapure purified water as an oxidizing agent was injected into the alumina (Al₂O₃)-supported platinum catalyst at 150°C and 1 torr for 15 seconds. Thereafter, maintenance was performed in a closed batch at 150°C and 3 torr for 600 seconds. After the maintenance, purging was performed for 600 seconds at 150°C and 1 torr. This was defined as one cycle of an ALD process of the present invention.

The above process was repeated two more cycles to finally manufacture a platinum catalyst (3 cycle Al₂O₃ coated Pt/γ-Al₂O₃) on which an inorganic film coated with Al₂O₃ was deposited to a thickness of 0.3 nm.

### Example 2

Example 2 was manufactured in the same manner as in Example 1, except that an injection time of an alumina precursor and an oxidizing agent was 1 second.

### Comparative Example 1

A platinum catalyst (Bare Pt/ γ-Al₂O₃) supported on an alumina support was prepared without performing an ALD process.

### Comparative Example 2

Trimethyl alumina (TMA, 99.999%, EG chem. Co., Ltd.) as an alumina precursor was injected into an alumina (Al₂O₃)-supported platinum (Pt) catalyst at 150°C and 1 torr for 15 seconds. Thereafter, purging was performed at 150°C and 1 torr for 600 seconds.

Next, ultrapure purified water as an oxidizing agent was injected into the alumina (Al₂O₃)-supported platinum catalyst at 150°C and 1 torr for 15 seconds. Thereafter, purging was performed at 150°C and 1 torr for 600 seconds. This was defined as one cycle of an ALD process of Comparative Example.

The above process was repeated four more cycles to finally manufacture a platinum catalyst (5 cycle Al₂O₃ coated Pt/γ-Al₂O₃) coated with Al₂O₃.

### Comparative Example 3

Comparative Example 3 was manufactured in the same manner as in Comparative Example 2, except that an ALD process was performed 10 cycles (10 cycle Al₂O₃ coated Pt/γ-Al₂O₃).

### Comparative Example 4

Comparative Example 4 was manufactured in the same manner as in Comparative Example 2, except that an ALD process was performed 20 cycles (20 cycle Al₂O₃ coated Pt/γ-Al₂O₃).

### Experimental Example 1-1: Evaluation of thermal stability of catalyst

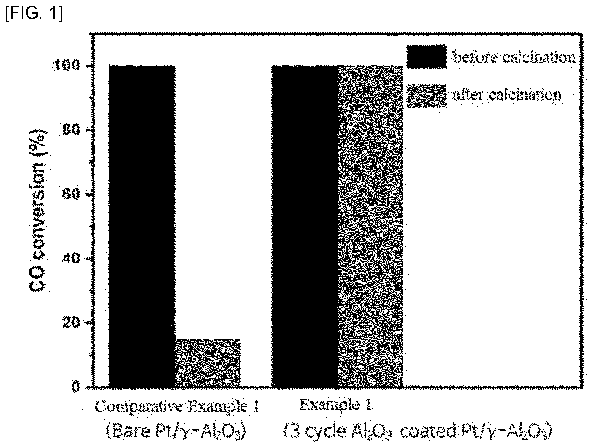

In order to confirm the thermal stabilities of the catalysts according to Example 1 and Comparative Example 1, activity changes before and after calcination were confirmed. The calcination was performed in air conditions at 500°C for 2 hours. In order to evaluate the activity in calcination conditions, CO oxidation was performed at 170°C and CO conversions (%) before and after calcination were measured and compared. As reaction gas, 5% CO (background gas air) was flowed into a reactor in an amount of 40 ml/min. In addition, before the reaction, reduction was performed at 500°C for 3 hours by using 3.9% H2 (background gas N2), and then CO oxidation reaction was performed. The results thereof are shown in FIG. 1.

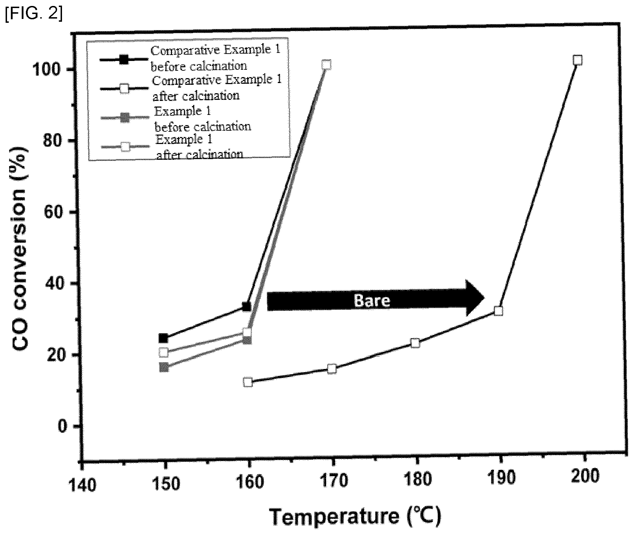

In addition, CO conversions (%) according to temperature were additionally measured. The results thereof are shown in FIG. 2.

### Experimental Example 1-2: Evaluation of thermal stability of catalyst

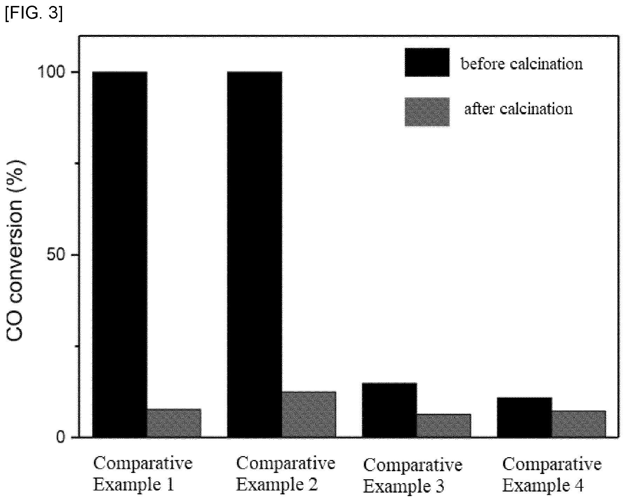

In order to confirm the thermal stabilities of Comparative Examples 1 to 4, activity changes before and after calcination were confirmed. The calcination was performed in air conditions at 500°C for 2 hours. In order to evaluate the activity in calcination conditions, CO oxidation was performed at 180°C and CO conversions (%) before and after calcination were measured. The results thereof are shown in FIG. 3.

### Experimental Example 1-3: Evaluation of thermal stability of catalyst

In order to confirm the thermal stabilities of the catalysts according to Examples 1 and 2 and Comparative Example 1, activity changes before and after calcination were confirmed. The calcination was performed in air conditions at 500°C for 2 hours. In order to evaluate the activity in calcination conditions, CO oxidation was performed at 170°C and CO conversions (%) before and after calcination were measured. The results thereof are shown in FIG. 4.

Referring to the results of FIG. 1 according to the present invention, in the case of Example 1, it was confirmed that the CO conversions (%) after CO oxidation were maintained at the same value before and after calcination. On the other hand, in the case of Comparative Example 1, which was Bare Pt/γ-Al₂O₃ on which the ALD process was not performed, it was confirmed that the activity was significantly reduced after the calcination was performed at a high temperature for a long time.

In the same context, referring to the results of FIG. 2 according to the present invention, in the case of the catalyst according to Example 1 in heat treatment calcination conditions at 500°C for 2 hours, the activity was maintained and a clear sintering prevention effect was confirmed. On the other hand, in the case of Comparative Example 1, it was confirmed that the activity was significantly reduced after calcination. A sharp decrease in CO conversion (%) was observed at the same temperature.

Referring to the results of FIG. 3 according to the present invention, in the case of Comparative Example 1 without providing an ALD process and Comparative Examples 2 to 4 without providing a maintenance step, it was confirmed that the activity after calcination was significantly reduced. Therefore, it can be confirmed that when the maintenance step is introduced into the ALD process, it greatly affects the maintenance of the activity.

Referring to the results of FIG. 4 according to the present invention, when comparing Examples 1 and 2, it was confirmed that the reactant injection time was reduced when the maintenance step was introduced into the ALD process. In particular, it was confirmed that even when the reactant injection time was reduced to 1 second, the activity was not affected and the sintering prevention effect was provided. This is meaningful in that it suggests that the maintenance step rather than the reactant injection time is an important process to coat the inside of the catalyst.

Therefore, the catalyst according to the present invention can provide optimal process conditions by introducing the maintenance step into the ALD process. In particular, in the case of introducing the maintenance step, it can be confirmed that even when the reactant injection time is reduced, the reactant penetrates into the internal structure of the porous catalyst, and thus, the adsorption of additional reactants affecting the activity and the sintering prevention effect can be suppressed.

Furthermore, when the maintenance step is introduced into the ALD process, it can be confirmed that the activity improvement can be provided differently depending on the ALD process conditions, and the same activity can be provided even after calcination under certain conditions.

While the present invention has been described by particular matters such as specific components and limited embodiments and drawings, this is provided only for helping the comprehensive understanding of the present invention. The present invention is not limited to the above-described embodiments, and it will be understood by those of ordinary skill in the art that various modifications and variations can be made thereto without departing from the scope of the present invention.

Therefore, it will be understood that the spirit of the present invention should not be limited to the above-described embodiments and the claims and all equivalent modifications fall within the scope of the present invention.

### INDUSTRIAL APPLICABILITY

According to the present invention, optimal process conditions can be provided by introducing the maintenance step into the ALD process. In particular, in the case of introducing the maintenance step, it can be even when the reactant injection time is reduced, the reactant penetrates into the internal structure of the porous catalyst, and thus, the adsorption of additional reactants affecting the activity and the sintering prevention effect can be suppressed.

According to the present invention, in the case of introducing the maintenance step into the ALD process, it can be confirmed that the activity improvement can be provided differently depending on the ALD process conditions, and the same activity can be provided even after calcination under certain conditions.

## Claims

1. A method for manufacturing a metal catalyst having an inorganic film deposited thereon by an atomic layer deposition (ALD) process, the method comprising:
a step (a) of injecting a precursor into a supported catalyst according to ALD to deposit the precursor on the surface of the catalyst;
a step (b) of performing maintenance;
a step (c) of performing purging;
a step (d) of depositing an inorganic film on the surface of the catalyst by injecting an oxidizing agent into the supported catalyst and reacting the oxidizing agent with the precursor deposited on the surface of the catalyst;
a step (e) of performing maintenance; and
a step (f) of performing purging.

2. The method of claim 1, wherein the catalyst in the step (a) is at least one selected from platinum (Pt), gold (Au), silver (Ag), copper (Cu), nickel (Ni), palladium (Pd), rhodium (Rh), and ruthenium (Ru).

3. The method of claim 1, wherein the supporting in the step (a) provides at least one selected from alumina, silica, zeolite, titania, zirconia, and carbon as a support.

4. The method of claim 1, wherein the precursor in the step (a) is a precursor capable of forming at least one selected from alumina (Al₂O₃), titania (TiO₂), zirconia (ZrO₂), zinc oxide (ZnO₂), gallium oxide (GaO₂), and ceria (CeO₂).

5. The method of claim 1, wherein the oxidizing agent in the step (d) is at least one selected from ultrapure purified water, alcohol, ozone, nitrous oxide, and oxygen.

6. The method of claim 1, wherein the inorganic film in the step (d) is at least one selected from alumina, titania, zirconia, zinc oxide, gallium oxide and ceria.

7. The method of claim 1, wherein an injection time of the injecting in the steps (a) and (d) is 0.5 seconds to 30 seconds.

8. The method of claim 1, wherein the injecting in the steps (a) and (d) is performed by injecting an inert gas as a carrier gas.

9. The method of claim 1, wherein the maintenance in the steps (b) and (e) is performed at a temperature of 50°C to 300°C.

10. The method of claim 1, wherein the maintenance in the steps (b) and (e) is performed at a pressure of 1 to 10 torr.

11. The method of claim 1, wherein the maintenance in the steps (b) and (e) is performed in a closed space.

12. The method of claim 1, wherein the purging in the (c) and (f) is performed by injecting an inert gas.

13. The method of claim 1, wherein the purging in the steps (c) and (f) is performed at a pressure of 0.001 to 1 torr.

14. The method of claim 1, wherein an atomic layer is deposited by performing the method 1 to 10 cycles.

15. A metal catalyst having an inorganic film deposited thereon, the metal catalyst being manufactured by the method of any one of claims 1 to 15.

16. The metal catalyst of claim 16, wherein a thickness of the inorganic film is 0.1 to 2 nm.
